# EUROPEAN PATENT SPECIFICATION

(11) **EP 1 499 549 B1**
(45) Date of publication and mention of the grant of the patent: **02.09.2009**
(21) Application number: 03725345.7
(22) Date of filing: 28.04.2003
(51) Int. Cl.: B65H 18/28, H05K 3/26, B65H 29/00, B65H 75/00

(54) **SHEETED ROLL**
BLATTZUGESCHNITTENE ROLLE
CYLINDRE RECOUVERT DE FEUILLES DE MATIERE

(30) Priority: 26.04.2002 GB 0209566; 03.05.2002 GB 0210162; 07.03.2003 GB 0305232
(43) Date of publication of application: 26.01.2005
(73) Proprietor: T H Group Limited, Inchinnan Renfrewshire PA4 9RT (GB)
(72) Inventor: HAMILTON, Sheila, Kilmacolm, Renfrewshire PA13 4JW (GB); KENNETT, Charles Jonathan, Howwood, Renfrewshire PA9 1DH (GB)
(74) Representative: Murnane, Graham John
(86) International application number: PCT/GB2003/001788
(87) International publication number: WO 2003/091138

(56) References cited:
- EP-A- 0 548 395
- US-A- 5 667 617
- PATENT ABSTRACTS OF JAPAN vol. 016, no. 515 (M-1329), 23 October 1992 (1992-10-23) -& JP 04 189738 A (NITTO DENKO CORP), 8 July 1992 (1992-07-08)
- PATENT ABSTRACTS OF JAPAN vol. 010, no. 114 (M-473), 26 April 1986 (1986-04-26) -& JP 60 242172 A (MOTOHARU NAKANO), 2 December 1985 (1985-12-02)

## Description

This invention relates to a sheeted roll, and in particular, but not exclusively, to a sheeted roll having individual lengths of material located around its outer circumference. The material may be an adhesive cleaning material which can used to remove impurities, or alternatively, the material may be a laminate or other adhesive material that requires to be dispensed. In addition, this invention relates to an apparatus for cleaning a workpiece comprising a sheeted adhesive roll used in combination with a cleaning roll , the sheeted adhesive roll removing impurities from a cleaning surface of the cleaning roll, the cleaning surface first removing the impurities from a surface of a workpiece.

Conventionally, apparatus for cleaning surfaces of a workpiece comprise at least one cleaning roll which is adapted to remove impurities from the workpiece.

The cleaning roll makes contact at a point with a surface of the workpiece removing any impurities thereon as the said workpiece is conveyed past the rotatablymounted cleaning roll.

Over a period of time, the cleaning roll will become contaminated with the impurities from the workpiece.

Conventionally, an adhesive roll with a continuous length of adhesive material is located adjacent to the cleaning roll. The adhesive roll makes contact at a point on the surface of the cleaning roll and in so doing, removes the impurities from the cleaning roll onto a portion of the continuous adhesive material located on the adhesive roll.

Subsequently, the said portion of the continuous adhesive material will require to be removed and replaced due to a build up of the impurities. This is normally done by a user cutting away the outer circumference of the used portion of the continuous adhesive material, leaving behind a new portion of continuous adhesive material for use.

Cutting of the used portion of the continuous adhesive material is done with the aid of a blade or knife. There is therefore a safety aspect to be considered to a user when cutting the said used portion of continuous adhesive material.

Furthermore, the cutting of the used portion of the continuous adhesive material can leave behind rough edges or fibres on the new portion of continuous adhesive material. This adversely affects the application of the new portion of continuous adhesive material onto the cleaning roll, resulting in impurities not being adequately removed or can cause contamination of the surrounding environment.

Conventional rolls of adhesive tape also have the disadvantage that they are in one continuous roll which makes cutting and obtaining specific lengths of adhesive tape difficult. There is also a safety aspect involved in using a blade or scissors to cut the continuous tape.

It is well known to use adhesive tape rolls for the removal of loose foreign matter from clothing fabrics. One such device disclosed in United States Patent No. 2,624,060 (McKenzie) comprises a wound tape of adhesive material separated into a series of individual sheets by the formation of a single generally radial slit through the roll. Of course, the existence of the slit means results in a discontinuous adhesive surface such that an inconsistent cleaning effect is produced during a single revolution of the roll.

According to a first aspect of the present invention there is provided a sheeted adhesive roll comprising a roll core having at least one sheet of adhesive cleaning material removably attachable thereon and subsequent sheets of said material then being removably attachable on previous sheets of said material on the roll core, said at least one sheet and subsequent sheets of adhesive cleaning material having a first adhesive surface covering the outwardly facing side of the sheet and a second non-adhesive surface on the other side of the sheet, the adhesive surface of each sheet holding the said sheets to one another on said roll core, the end of each sheet being adhered to the adhesive surface of that or the previous adhesive sheet on the roll, wherein the adhesive sheets are all of the same length such that their respective ends are offset circumferentially to provide a continuous adhesive surface.

Preferably, each sheet is greater in length than the circumference of the roll core.

Preferably, one end of each sheet is abutted to an end of another sheet.

Preferably, the adhesive is a pressure sensitive adhesive.

Preferably, the sheets are adapted to be dispensed.

Preferably, the material is dry-film photopolymer laminate.

Preferably, the laminate is a backing film having an acrylic photosensitive emulsion.

The material may be coated with a release coating which facilitates removal of each sheet.

For example, the material may be a dry-film photopolymer laminate that is dispensed from the sheeted roll and applied to the surface of a work piece and the laminate is a Mylar® backing film having an acrylic photosensitive emulsion for imaging of a circuit board.

According to a second aspect of the present invention, there is provided an apparatus for cleaning a workpiece comprising a sheeted adhesive roll according to the first aspect and at least one cleaning roll having a cleaning surface, the cleaning roll being rotatably mountable adjacent to a workpiece, the sheeted adhesive roll being rotatably mounted adjacent the cleaning roll relative to the workpiece.

Embodiments of the present invention will now be described, by way of example only, with reference to the accompanying drawings in which:-
Fig.1 is a side view of conventional apparatus for cleaning a workpiece;
Fig.2 is a view from one end of an adhesive roll illustrating how sheets of material are superimposed onto a roll core made in accordance with the present invention;
Fig.3 is a view from one end illustrating an alternative means of superimposing sheets of material onto a roll, not forming part of the present invention;
Fig.4 is a schematic view of apparatus for sheeting a roll but not forming part of the present invention;
Fig.5 is a side sectional view of a cutting roller of part of the apparatus of Fig.4;
Fig.6 is a top view of cutting roller of the apparatus of Fig.5;
Fig.7 is an end view of cutting roller; and
Fig.8 is a detail of a cleaning roll in accordance with the present invention produced by the apparatus of Figs 4-7.

Referring to the drawings, conventional apparatus 10 for cleaning a workpiece 20 advantageously comprises at least one cleaning roll 16 having a cleaning surface 18, and a roll core 12 having a continuous length of adhesive material 14 with an adhesive surface.

The cleaning roll 16 is rotatably mountable adjacent to the workpiece 20 in such a way that allows the cleaning surface 18 to be in contact at a point on a surface of the workpiece 20. Hence, as the workpiece 20 is conveyed, the cleaning roll 16 rotates and the cleaning surface 18 of the cleaning roll 16 removes any impurities located on the workpiece 20.

The cleaning surface 18 is typically elastomer coated or made of other forms of rubber or like material to facilitate the removal of impurities from the workpiece 20.

The roll core 12 is mountably rotatable above the cleaning roll 16 relative to the workpiece 20. The roll core 12 and continuous adhesive material 14 is in contact at a point with the cleaning surface 18 of the cleaning roll 16.

The continuous adhesive material 14 facilitates the removal of impurities from the cleaning surface 18 of the cleaning roll 16 to the continuous adhesive material 14 by virtue of being in contact at a point on the cleaning surface 18.

The continuous adhesive material 14 is applied in this way, as opposed to being directly applied onto the conveyed workpiece 20, to avoid contaminating the workpiece 20 with adhesive from the continuous adhesive material 14.

When the continuous adhesive material 14 becomes contaminated, replacement is achieved by a user cutting away the contaminated portion of the continuous adhesive material 14, leaving behind a new clean portion of continuous adhesive material 14 for use.

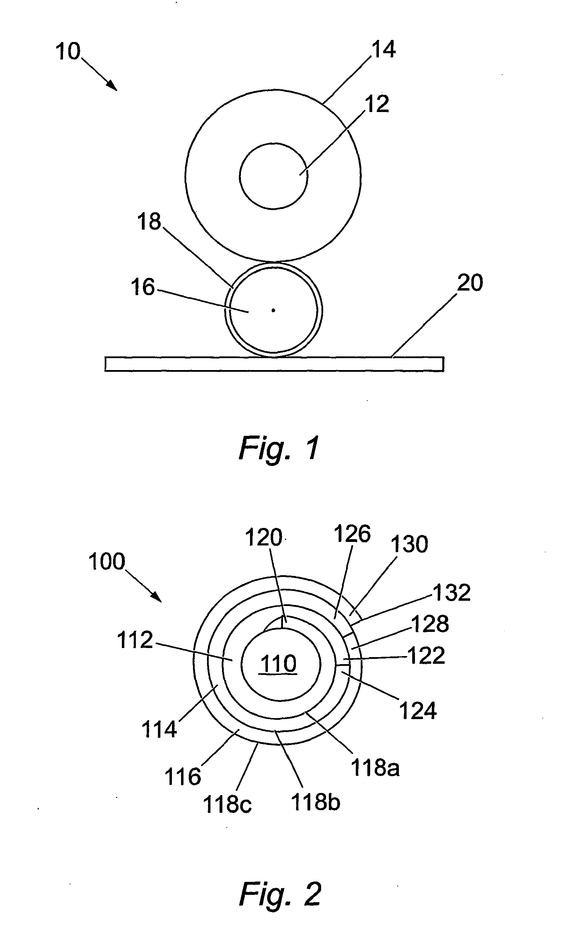

Fig. 2 shows a sheeted roll 100 in accordance with the present invention which comprises a conventional roll core 110 with individual adhesive sheets 112, 114, 116 removably attachable around the circumference of the roll core 110 superimposed onto one another.

The roll core 110 has an attachment means which may be an adhesive coating to allow the first individual adhesive sheet 112 to be removably attachable around the circumference of the roll core 110.

The individual adhesive sheets 112, 114, 116 have an adhesive surface 118a-c facing outwardly, and have a non-adhesive surface facing inwardly, Fig. 2. Alternatively the individual sheets can be rolled such that the adhesive surfaces are facing inwardly and the non-adhesive surfaces are facing outwardly.

The sheeted roll 100 is formed by attaching a first end 120 of the first sheet 112 onto the roll core 110 and wrapping the first sheet 112 around the circumference of the roll core 110.

The other end 122 of the first sheet 112 will overlap end 120 by virtue of the first sheet 112 being greater in length than the circumference of the roll core 110.

The end 122 is removably attached on end 120 by the adhesive surface 118a of the first sheet 112.

A second sheet 114 is then wrapped around the outer circumference of the first sheet 112 with end 124 of the second sheet 114 being abutted to end 122 of the first sheet 112. The term abutted is to be understood to include being adjacent to; there may be a gap between successive sheets.

The adhesive surface 118a of the first sheet 112 will securely hold in place the second sheet 114.

A third sheet 116 is then wrapped around the outer circumference of the second sheet 114 with end 128 of the third sheet 116 being abutted to end 126 of the second sheet 114.

The adhesive surface 118b of the second sheet 114 will securely hold in place the third sheet 116.

Similarly, further individual adhesive sheets (not shown) are abutted to end 130 of the third sheet 116 and so on until the roll core 110 is "full".

It will be realised that because the sheets 112, 114, 116 are all of the same length, the overlap or circumferential offset of the respective ends 122, 126, 130, and so on, will decrease as the roll core 12 becomes "full". The length of each sheet can however be adjusted as desired or required.

The offset of the abutment of the ends of the sheets disperses the load on the roll core 110 making the roll core 110 more stable when rotating.

In use, the roll core 110 is positioned such that the outermost sheet 116 is positioned in contact at a point with the cleaning surface 18 of the conventional cleaning roll 16.

As both the roll core 110 and the cleaning roll 16 rotate, impurities located on the cleaning surface 18 will be transferred to the adhesive surface 118c of the outer sheet 116.

When the adhesive surface 118c of the outer sheet 116 becomes contaminated, replacement is simply achieved by peeling the contaminated sheet 116 away by virtue of lip 132, thus leaving behind a clean sheet 114 to be applied to the cleaning surface 18 of the cleaning roll 16, until that too needs replaced, and so on.

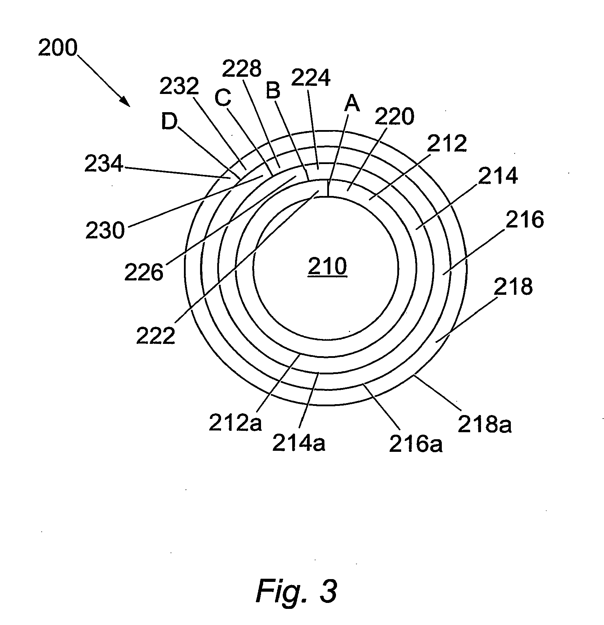

Fig. 3 shows an alternative example in the form of a sheeted roll 200 (not forming part of the present invention) comprising a conventional roll core 210 with individual adhesive sheets 212, 214, 216, 218, and so on, removably attachable around the circumference of the roll core 210 superimposed onto one another.

In this alternative example, a first sheet 212 is attached to the roll core 210. The sheet 212 has an adhesive surface 212a which faces outwardly and has a non-adhesive surface which faces inwardly. Unlike the sheeted roll of the present invention, the length of the first sheet 212 is equivalent to the circumference of the roll core such that its ends 220, 222 abut with one another. Abut should be understood to include the ends being adjacent to one another; there may be a gap between successive sheets.

A second sheet 214 is then removably attached to the first sheet 212, by virtue of the adhesive surface 212a of the first sheet 212. The length of this second sheet 214 is such that corresponding ends 224, 226 of the second sheet 214 abut with one another.

Similarly further sheets 216, 218, and so on, are removably attached to previous sheets 214, 216, 218, and so on. These further sheets 216, 218, and so on, are held securely in place by virtue of the adhesive surfaces 214a, 216a, 218a, and so on.

Points A, B, C, D indicate the position of abutment of the respective ends 220, 222, 224, 226, 228, 230, 232, 234. These points A, B, C, D are circumferentially spaced around the roll core 210 to facilitate replacement of the sheets 212, 214, 216, 218, and to maintain the structural integrity of the sheeted roll 200.

The length of each sheet can be adjusted as the roll becomes more "full" and the effective circumference becomes larger.

Whilst the present invention as illustrated in Fig. 2 has been described in relation to an adhesive material, it is also applicable to dry-film photopolymer laminate materials used particularly but not exclusively for imaging of circuit board materials, or any material having a sticky or tacky character.

An example of such laminates is a Mylar® backing film having an acrylic photosensitive emulsion.

Furthermore, it is to be realised that the present invention may be used for dispensing.

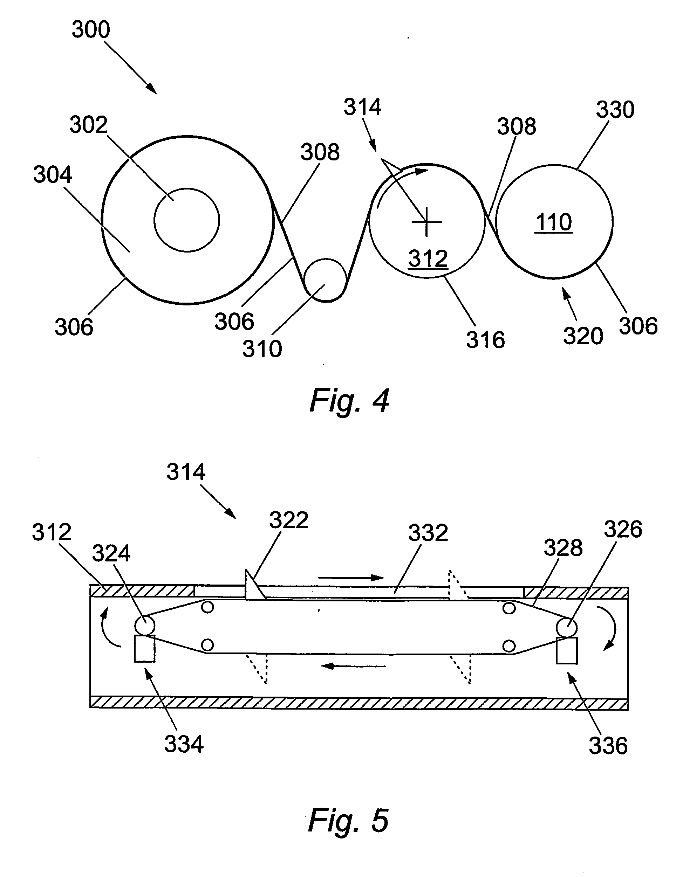

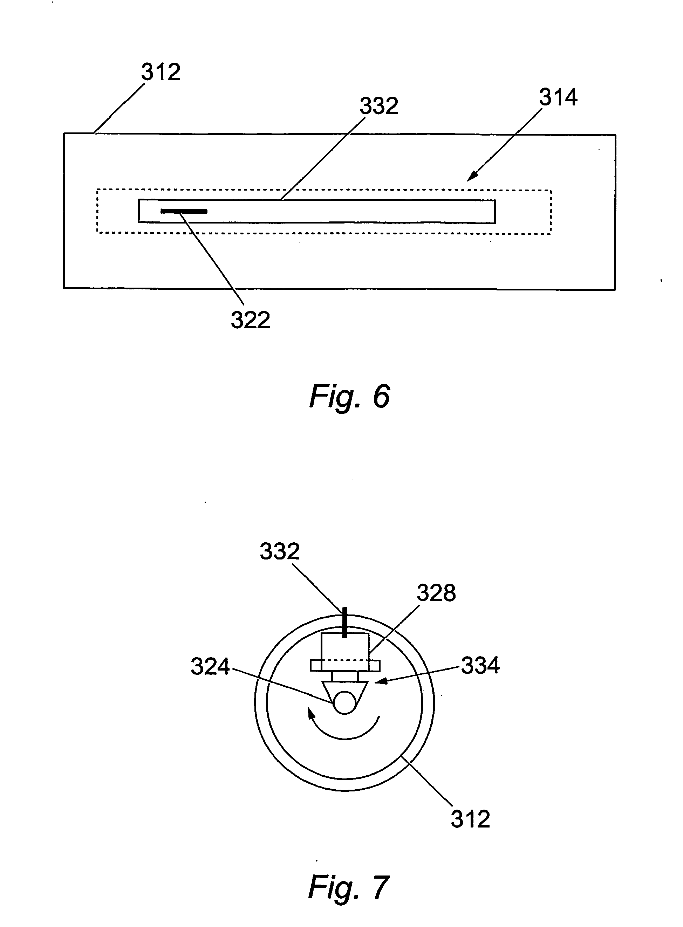

Referring now to Figs. 4 to 7 of the drawings, the apparatus 300 for sheeting a roll (again, not forming part of the present invention) comprises a feed roller 302 provided with a continuous adhesive material 304, a guide roller 310 to transfer and guide the continuous adhesive material 304 onto surface 316 of a cutting roller 312, the cutting roller 312 provided with cutting means 314 to cut the continuous adhesive material 304 into individually cut sheets 320 which are then removably applied to a sheeting roller 110.

The feed roller 302 is provided with a continuous adhesive sheet 304 with an internal adhesive surface 118 and an external non-adhesive surface 308. The sheet may comprise polyester or paper coated with a pressure sensitive adhesive.

The sheets can be rolled such that the adhesive layer is facing either inwardly or outwardly.

The feed roller 302 provided with the continuous adhesive material is typical of that known in the art.

The guide roller 310 guides and aligns the continuous adhesive material 304 on to surface 316 of the cutting roller 312.

The cutting roller 312 is hollow and has a non-stick surface 316 (formed of a material such as Teflon®) which allows the adhesive material 304 to be removably attached thereon, with the adhesive surface 118 facing inwardly towards the centre of the cutting roller 312, and the non-adhesive surface 308 facing outwardly, or vice versa.

The cutting means 314 comprises a blade 322 mounted on a drive belt 328, the drive belt 328 being conveyed between two co-planar rotating spindles 324, 326. The blade 322 protruding through a slot 332 in the cutting roller 312 to cut the adhesive material 304.

The rotating spindles 324, 326 are carried by supports 334, 336 which rotate with the rotating cutting roller 312 and thus ensures that the cutting means 314 moves at the same linear speed as the surface of the cutting roller 312.

The cutting means 314 is such that cutting of the adhesive material 304 will only occur along the slot 332.

A cut sheet is then fed to the sheeting roller 110 which is provided with an adhesive surface 330 to hold a first cut sheet 112 to the circumference of the sheeting roller 110, Fig. 2.

The cut sheets 112-116 (Fig. 2) produced by the cutting roller 312 will be substantially the same length dictated by the speed of rotation of the cutting roller 312 and the timing of the operation of the cutting means 314.

Therefore, in use, sheeting apparatus 300 forms the sheeted roll 100 of the present invention in accordance with the following description.

The continuous adhesive material 304 located on the feed roller 302 is initially fed around the guide roller 310 and onto surface 316 of the cutting roller 312. The adhesive material 304 is removably attachable by virtue of the adhesive surface 306.

The sheeting apparatus 300 is then selectively operated to run for a duration which allows the cutting means 314 to cut a first cut sheet 112 which is then located onto the sheeting roller 110 to assist in forming a sheeted roll 100 as shown in Fig. 2.

End 120 of the first cut sheet 112 is attachable to a surface 330 of the sheeting roller 110, while the other end 122, is wrapped around the outer' circumference of the sheeting roller 110 until end 122 overlaps with end 120.

The sheeting apparatus 300 once again is selectively operated to convey the adhesive material 304 past the cutting means 314.

As the adhesive material 304 passes by the slot 332, the blade 322 will protrude from the slot 332 and cut a second cut sheet 114.

The cut sheet 114 will then be conveyed onto the outer circumference of the sheeted roll 100 with end 124 of the second cut sheet 114 abutted with end 122 of the first cut sheet 112. The other end 126 of the second cut sheet 114 is wrapped around the outer circumference of the first cut sheet 112.

The adhesive material 304 is then cut again by the blade 322 of the cutting means 314 within the cutting roller 312 to cut a third cut sheet 116.

One end 128 of the third sheet 116 is abutted against end 126 of the second cut sheet 114. The third cut sheet 116 is then wrapped around the outer circumference of the second cut sheet 114.

Further cut sheets (not shown) are applied onto one another around the outer circumference of the sheeted roll 100 in the same way as described above until the sheeting roller 110 is "full".

It will be recognised that as more and more cut sheets are located on sheeting roller 110, the amount of overlap or offset will decrease as the outer circumference of the sheeted roll 100 expands with the cut sheets located thereon. The offset in the abutment of the ends disperses the load on the sheeting roller 110 making the sheeted roll 100 more stable when rotating and maintains the structural integrity.

When "full", the sheeting roller 110 is applied to apparatus 10 for cleaning a workpiece 18 as shown in Fig. 1.

The sheeting apparatus 300 can either be located remote or adjacent to the cleaning apparatus 10. If located adjacent then it will be recognised that the sheeting roller 316 may be adapted to be removably attachable and selectively operable between the cleaning apparatus 10 and the sheeting apparatus 300.

It will be recognised that the overlap forms a lip 132 which facilitates simple replacement of contaminated cut sheets.

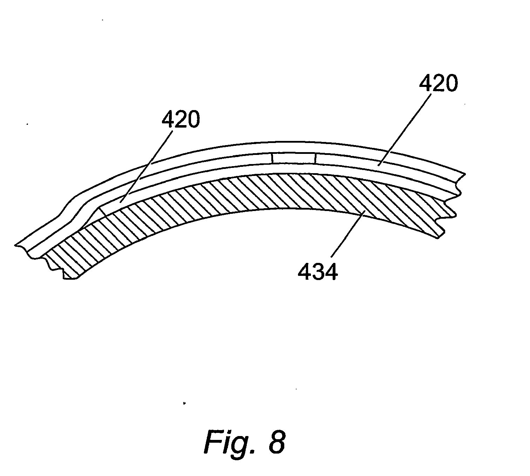

It will be understood however that the thickness of the sheets 420 is greatly exaggerated in Figure 8, and the overlap does not cause any problems in practice.

Modifications and improvements may be made to the above without departing from the scope of the present invention. It is clear that the foregoing provides sheeted rolls with the adhesive facing inwardly or outwardly. Also, for example, the sheeted roll may have a roll core with individual sheets of any length removably attachable onto the roll core. Also, the cutting means instead of being positioned within a cutting roller may be located proximate to the cutting roller. Furthermore, the individually cut sheets need not be located onto a sheeting roller. Instead, the cut sheets may be overlaid onto one another into a container.

## Claims

1. A sheeted adhesive roll (100) comprising a roll core (110) having at least one sheet (112) of adhesive cleaning material removably attachable thereon and subsequent sheets (114,116) of said material then being removably attachable on previous sheets of said material on the roll core, said at least one sheet (112) and subsequent sheets (114, 116) of adhesive cleaning material having a first adhesive surface covering the outwardly facing side of the sheet and a second non-adhesive surface on the other side of the sheet, the adhesive surface (118) of each sheet (112, 114, 116) holding the said sheets to one another on said roll core (110), the end of each sheet being adhered to the adhesive surface of that or the previous adhesive sheet on the roll (100), **characterised in that** the adhesive sheets are all of the same length such that their respective ends (122, 124, 126, 128, 130) are offset circumferentially to provide a continuous adhesive surface.

2. The sheeted roll (100) of claim 1, wherein each sheet is greater in length than the circumference of the roll core (110).

3. The sheeted roll of one of claim 1 or 2, wherein one end of each sheet is abutted to an end of another sheet.

4. The sheeted roll of any one of claims 1 to 3, wherein the adhesive is a pressure sensitive adhesive.

5. The sheeted roll of any one of claims 1 to 4, wherein the sheets are adapted to be dispensed.

6. The sheeted roll of any one of claims 1 to 5, wherein the material is dry-film photopolymer laminate.

7. The sheeted roll of claim 6, wherein the laminate is a backing film having an acrylic photosensitive emulsion.

8. An apparatus for cleaning a workpiece comprising a sheeted adhesive roll (100) according to any one of claims 1 to 7 and at least one cleaning roll (16) having a cleaning surface (18), the cleaning roll (16) being rotably mountable adjacent to a workpiece (20), the sheeted adhesive roll (100) being rotatably mounted adjacent the cleaning roll (16) relative to the workpiece (20).

9. Apparatus as claimed in claim 8, wherein the workpiece (20) is an electronic circuit board.

## Patentansprüche

1. Eine mit Blättern versehene klebende Walze (100), die einen Walzenkern (110) mit mindestens einem Blatt (112) eines daran entfernbar befestigbaren klebenden Reinigungsmaterials beinhaltet und bei der nachfolgende Blätter (114, 116) des Materials dann entfernbar an vorherigen Blättern des Materials auf dem Walzenkern befestigt werden können, wobei das mindestens eine Blatt (112) und nachfolgende Blätter (114, 116) des klebenden Reinigungsmaterials eine erste klebende Oberfläche, die die nach außen weisende Seite des Blatts bedeckt, und eine zweite, nichtklebende Oberfläche auf der anderen Seite des Blatts aufweisen, wobei die klebende Oberfläche (118) jedes Blatts (112, 114, 116) die Blätter auf dem Walzenkern (110) aneinander festhält, wobei das Ende jedes Blatts an die klebende Oberfläche dieses oder des vorherigen klebenden Blatts auf der Walze (100) geklebt ist, **dadurch gekennzeichnet, dass** die klebenden Blätter alle von gleicher Länge sind, so dass ihre jeweiligen Enden (122, 124, 126, 128, 130) den Umfang betreffend versetzt sind, um eine kontinuierliche klebende Oberfläche bereitzustellen.

2. Mit Blättern versehene Walze (100) gemäß Anspruch 1, wobei die Länge jedes Blatt größer als der Umfang des Walzenkerns (110) ist.

3. Mit Blättern versehene Walze gemäß einem der Ansprüche 1 oder 2, wobei ein Ende jedes Blatts an ein Ende eines anderen Blatts angrenzt.

4. Mit Blättern versehene Walze gemäß einem beliebigen der Ansprüche 1 bis 3, wobei der Klebestoff ein Haftklebstoff ist.

5. Mit Blättern versehene Walze gemäß einem beliebigen der Ansprüche 1 bis 4, wobei die Blätter angepasst sind, um gelöst zu werden.

6. Mit Blättern versehene Walze gemäß einem beliebigen der Ansprüche 1 bis 5, wobei das Material ein Trockenfilm-Photopolymer-Laminat ist.

7. Mit Blättern versehene Walze gemäß Anspruch 6, wobei das Laminat eine Trägerfolie mit einer lichtempfindlichen Acrylemulsion ist.

8. Eine Vorrichtung zum Reinigen eines Arbeitsstücks, die eine mit Blättern versehene klebende Walze (100) gemäß einem beliebigen der Ansprüche 1 bis 7 und mindestens eine Reinigungswalze (16) mit einer Reinigungsoberfläche (18) beinhaltet, wobei die Reinigungswalze (16) drehbar neben einem Arbeitsstück (20) montiert werden kann, wobei die mit Blättern versehene klebende Walze (100) relativ zu dem Arbeitsstück (20) drehbar neben der Reinigungswalze (16) montiert ist.

9. Vorrichtung gemäß Anspruch 8, wobei das Arbeitsstück (20) eine elektronische Schaltkarte ist.

## Revendications

1. Un rouleau adhésif à feuilles (100) comprenant un mandrin (110) présentant au moins une feuille (112) de matériau nettoyant adhésif qui peut être attachée de façon amovible sur celui-ci et des feuilles subséquentes (114, 116) dudit matériau qui peuvent ensuite être attachées de façon amovible sur des feuilles précédentes dudit matériau sur le mandrin, lesdites au moins une feuille (112) et feuilles subséquentes (114, 116) de matériau nettoyant adhésif ayant une première surface adhésive qui couvre le côté tourné vers l'extérieur de la feuille et une deuxième surface non adhésive sur l'autre côté de la feuille, la surface adhésive (118) de chaque feuille (112, 114, 116) maintenant lesdites feuilles les unes sur les autres sur ledit mandrin (110), l'extrémité de chaque feuille étant collée à la surface adhésive de cette ou de la feuille adhésive précédente sur le rouleau (100), **caractérisé en ce que** les feuilles adhésives sont toutes de la même longueur de sorte que leurs extrémités respectives (122, 124, 126, 128, 130) soient décalées circonférentiellement afin de fournir une surface adhésive continue.

2. Le rouleau à feuilles (100) de la revendication 1, dans lequel chaque feuille est de longueur supérieure à la circonférence du mandrin (110).

3. Le rouleau à feuilles de l'une des revendications 1 et 2, dans lequel une extrémité de chaque feuille est aboutée à une extrémité d'une autre feuille.

4. Le rouleau à feuilles de l'une quelconque des revendications 1 à 3, dans lequel l'adhésif est un adhésif sensible à la pression.

5. Le rouleau à feuilles de l'une quelconque des revendications 1 à 4, dans lequel les feuilles sont adaptées pour être distribuées.

6. Le rouleau à feuilles de l'une quelconque des revendications 1 à 5, dans lequel le matériau est du stratifié photopolymère en film sec.

7. Le rouleau à feuilles de la revendication 6, dans lequel le stratifié est un film support à émulsion photosensible acrylique.

8. Un appareil pour nettoyer une pièce à usiner comprenant un rouleau adhésif à feuilles (100) selon l'une quelconque des revendications 1 à 7 et au moins un rouleau nettoyant (16) présentant une surface nettoyante (18), le rouleau nettoyant (16) étant montable de manière à ce qu'il puisse tourner adjacent à une pièce à usiner (20), le rouleau adhésif à feuilles (100) étant monté de manière à ce qu'il puisse tourner adjacent au rouleau nettoyant (16) par rapport à la pièce à usiner (20).

9. Appareil tel que revendiqué dans la revendication 8, dans lequel la pièce à usiner (20) est une carte de circuit électronique.
